(19) Europäisches Patentamt
European Patent Office
Office européen des brevets

(11) **EP 2 577 820 B1**

(12) **EUROPÄISCHE PATENTSCHRIFT**

(45) Veröffentlichungstag und Bekanntmachung des Hinweises auf die Patenterteilung:
**18.02.2015 Patentblatt 2015/08**

(21) Anmeldenummer: **11738950.2**

(22) Anmeldetag: **01.06.2011**

(51) Int Cl.:
***H01S 3/139*** *(2006.01)*    ***H01S 5/14*** *(2006.01)*
***H01S 3/109*** *(2006.01)*

(86) Internationale Anmeldenummer:
**PCT/EP2011/002705**

(87) Internationale Veröffentlichungsnummer:
**WO 2011/151062 (08.12.2011 Gazette 2011/49)**

(54) **VERFAHREN ZUM ERZEUGEN VON PHASENKOHÄRENTEN LICHTFELDERN MIT VORGEBBAREM WERT IHRER FREQUENZ UND OPTISCHER FREQUENZ-SYNTHESIZER**

METHOD FOR GENERATING PHASE-COHERENT LIGHT FIELDS HAVING A PREDETERMINED FREQUENCY AND OPTICAL FREQUENCY SYNTHESIZER

MÉTHODE POUR GÉNÉRER DES CHAMPS LUMINEUX EN PHASE COHÉRENTE ET SYNTHÉTISEUR DE FRÉQUENCE OPTIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **03.06.2010 DE 102010022585**

(43) Veröffentlichungstag der Anmeldung:
**10.04.2013 Patentblatt 2013/15**

(73) Patentinhaber: **Bundesrepublik Deutschland, Vertreten Durch Das Bundesministerium Für Wirtschaft Und Technologie,
Dieses Vertreten Durch Den Präsidenten Der 38116 Braunschweig (DE)**

(72) Erfinder:
• **TELLE, Harald
38518 Gifhorn (DE)**
• **BENKLER, Erik
38106 Braunschweig (DE)**

(74) Vertreter: **Isfort, Olaf
Schneiders & Behrendt
Rechts- und Patentanwälte
Huestraße 23
44787 Bochum (DE)**

(56) Entgegenhaltungen:
**WO-A2-02/099939    JP-A- 2002 076 507**

• **BEVERINI N. ET AL.: "Phase locking of a diode laser to a Ti:Sa comb by means of an analog+digital phase-frequency detector", LASER OPTICS 2003. SOLID STATE LASERS AND NONLINEAR FREQUENCY CONVERSION 30 JUNE-4 JULY 2003 ST. PETERSBURG, RUSSIA, Bd. 5478, Nr. 1, 2004, Seiten 194-203, XP009151752, Proceedings of the SPIE - The International Society for Optical Engineering SPIE-Int. Soc. Opt. Eng. USA ISSN: 0277-786X, DOI: DOI:10.1117/12.560970**
• **NAKAGAWA K ET AL: "PROPOSAL OF A FREQUENCY-SYNTHESIS CHAIN BETWEEN THE MICROWAVE AND OPTICAL FREQUENCIES OF THE CA INTERCOMBINATION LINE AT 657 NM USINGDIODE LASERS", APPLIED PHYSICS B. PHOTOPHYSICS AND CHEMISTRY, SPRINGER VERLAG. HEIDELBERG, DE, Bd. B57, Nr. 6, 1. Dezember 1993 (1993-12-01), Seiten 425-430, XP000423113, DOI: 10.1007/BF00357386**

**Beschreibung**

Die Erfindung betrifft ein Verfahren zum Erzeugen eines phasenkohärenten Lichtfeldes mit vorgebbarem Wert seiner Frequenz und ein Verfahren zum Erzeugen eines phasenkohärenten Lichtfeldes einer Frequenz, deren Wert sich mit der Zeit gemäß einem vorgegebenen Verlauf ändert. Gemäß einem zweiten Aspekt betrifft die Erfindung einen optischen Frequenz-Synthesizer.

Für vielerlei Anwendungen, beispielsweise in der Spektroskopie, ist es vorteilhaft, monochromatische, phasenkohärente Lichtfelder mit vorgebbarem Wert ihrer Frequenz erzeugen zu können, wobei dieser Frequenzwert mit hoher Genauigkeit bekannt sein soll. Das ist für bestimmte, eingeschränkte Frequenzintervalle bereits erreichbar, bislang ist es aber nicht möglich, eine breitbandig durchstimmbare Lichtquelle mit phasenkohärentem Emissionsfeld zu bauen, bei der für jede Frequenz innerhalb des Abstimmbereichs der Frequenzwert mit hoher Genauigkeit bekannt ist.

In einer Veröffentlichung von N. Beverini et al., Laser Optics 2003, Solid State Lasers and Nonlinear Frequency Conversion, Proceedings of the SPIE Vol. 5478, Nr. 1, Seiten 194 - 203 wird die phasenstarre Kopplung eines Diodenlasers an einen durch einen Ti:Sa-Laser erzeugten optischen Frequenzkamm mittels eines analog-digitalen Phasen-Frequenz-Detektors beschrieben. Die Druckschrift WO 02/099939 A2 (University College, London) beschreibt einen optischen Frequenz-Synthesizer mit einer Vorrichtung zur Laser-Frequenzverriegelung.

Der Erfindung liegt die Aufgabe zugrunde, phasenkohärente Lichtfelder mit einer frei vorgebbaren Frequenz verfügbar zu machen, wobei der Frequenzwert mit hoher Genauigkeit einstellbar und im Prinzip auf die SI-Sekunde rückführbar ist.

Die Erfindung löst das Problem durch ein Verfahren zum Erzeugen von Licht eines vorgebbaren Frequenzwertes $\nu_{Soll}$ mit den Schritten (a) Erzeugen von Arbeits-Licht mit einer Arbeits-Frequenz $\nu_{SL}$, (b) Erzeugen eines Lichtfeldes mit frequenzkamm-förmigen Spektrum, das aus äquidistanten, phasenkohärenten Einzellinien besteht, (c) Auswählen einer Kammlinie des Frequenzkamms (Laufindex m) mit dem Frequenzwert $\nu_m$, (d) Erzeugen einer Frequenz-Verschiebung des Frequenzkamms und/oder der Arbeits-Frequenz durch Phasenstellungen $\varphi_S(t)$, deren maximale Größe auf den Wert $2\pi$ beschränkt sein darf.

Gemäß einem zweiten Aspekt löst die Erfindung das Problem durch einen optischen Frequenz-Synthesizer mit (i) einer abstimmbaren Arbeits-Lichtquelle zum Abgeben von Arbeits-Licht mit einer Arbeits-Frequenz, (ii) einem Lichteingang zum Einkoppeln eines Lichtfeldes, dessen Spektrum aus äquidistanten, phasenkohärenten Einzellinien besteht, (iii) einer Frequenz/Phasen-Steuerung, die eingerichtet ist zum Erzeugen einer Frequenz-Verschiebung des Frequenzkammlichtes und/oder des Arbeits-Lichtes durch veränderliche Phasenstellungen $\varphi_S(t)$ und (iv) einer Phasenregelung zum Regeln der Frequenz/Phase des ggf. frequenzverschobenen Arbeitslichts auf die Frequenz/Phase des Feldes einer ggf. frequenzverschobenen Frequenzkammlinie.

Unter der Phasenstellung $\varphi_S(t)$ wird die Phasendifferenz zwischen dem Ein- und Ausgang des Phasen-Stellglieds verstanden. Zeitliche Veränderungen der Phasenstellungen innerhalb einer Inversen des Kammlinienabstandes werden als Phasenstellungsfortschritt $\Delta\varphi_S$ bezeichnet.

Gemäß eines dritten Aspekts löst die Erfindung das Problem durch einen optischen Frequenz-Synthesizer, bei dem das frequenzverschobene Lichtfeld der ausgewählten Kammlinie so herausgefiltert wird, dass nur noch ein monochromatisches, phasenverfolgbares Dauerstrichfeld verbleibt. Dies kann beispielsweise durch einen leeren passiven Resonator oder einem passiven Resonator mit interner Frequenzverdopplung geschehen.

Vorteilhaft an der Erfindung ist, dass grundsätzlich jeder Frequenz-Sollwert innerhalb des Abstimmbereichs der Arbeitslichtquelle vorgegeben werden kann. Die Werte aller Frequenzen können phasenstarr auf eine Atomuhr zurückgeführt werden und sind daher mit hoher Genauigkeit einstellbar.

Vorteilhaft ist zudem, dass mit Hilfe der Erfindung ein schnelles und gleichzeitig präzises Durchstimmen eines Dauerstrich(CW)-Lasers ermöglicht wird.

Im Rahmen der vorliegenden Beschreibung wird unter dem Erzeugen von Arbeits-Licht mit der Arbeits-Frequenz insbesondere das Erzeugen eines phasenkohärenten, monochromatischen Laserstrahls verstanden. Hierzu wird beispielsweise ein durchstimmbarer Laser als Arbeits-Lichtquelle verwendet. Beispielsweise kann eine Extended-Cavity-Laser-Diode verwendet werden. Derartige Dioden sind vergleichsweise einfach aufgebaut und damit wirtschaftlich betreibbar.

Das Arbeits-Licht kann eine Frequenz im sichtbaren Spektralbereich haben. Möglich ist auch, dass das Arbeits-Licht im Infraroten und/oder Ultravioletten liegt.

Unter dem Frequenzkamm wird ein Lichtfeld entsprechend einer Mehrzahl von äquidistanten Spektrallinien verstanden, wobei die Schwingungsphase jeder einzelnen Linie zeitlich verfolgbar ist. Ein solcher Frequenzkamm kann als durch zeitlich periodische Modulation einer Trägerschwingung mit einer Trägerfrequenz $\nu_C$ durch eine periodische, komplexwertige Einhüllende mit einer Repetitionsfrequenz $f_{REP}$ erhalten beschrieben werden. In vielen Fällen ist diese periodische komplexwertige Einhüllende eine Amplitudenmodulation in Form kurzer Impulse. Deshalb wird im Folgenden der Begriff 'Impuls' synonym zum Begriff 'komplexwertige Einhüllende' verwendet.

Als Frequenzkamm wird in der Regel ein Lichtfeld mit schmalbandigen, äquidistanten Emissionslinien bezeichnet, die typischerweise einen Spektralbereich von 10 Nanometer bis 100 Nanometer überstreichen. Prinzipiell können diese Frequenzkammlinien-Felder in eine feste Frequenz- bzw. Phasenbeziehung zu den Emissionsfeldern von Lasern gesetzt werden, deren Frequenzwerte mit denen atomarer Resonanzen übereinstimmen. Unter dem Erzeugen eines Frequenzkamms wird insbesondere das Erzeugen eines selbstreferenzierten Frequenzkamms verstanden, bei dem die sog. *carrier-envelope-offset*-Frequenz $v_{CEO}$ und -Phase $\varphi_{CE}$ bekannt ist.

Günstig ist es, wenn die Frequenzen der Frequenzkammlinien auf die einer Atomuhr frequenzstabilisiert sind. Beispielsweise kann die Repetitionsfrequenz, die eine Mikrowellenfrequenz ist, auf eine Mikrowellen-Atomuhr stabilisiert sein. Auf diese Weise sind die Abstände der einzelnen Frequenzen im Frequenzkamm mit besonders hoher Genauigkeit bekannt. Alternativ oder additiv kann der Wert der Trägerfrequenz von einem als Frequenznormal dienenden hochgenauen Laser stammen.

Unter dem Merkmal, dass das Feld der Arbeitslichtquelle und das einer ausgewählten Kammlinie phasengekoppelt sind, wird insbesondere verstanden, dass eine spektrale Verschiebung des gesamten Frequenzkamms stets zu einer entsprechenden Verschiebung der Arbeitsfrequenz führt.

Ein Kerngedanke der Erfindung ist, dass im Fall eines zeitlich periodisch modulierten Trägersignals (Frequenzkamm) nur endlich große Phasenstellungen für beliebig große Phasenänderungen des Arbeitslichtes benötigt werden, sofern sie im Takt der Modulation auf der Repetitionsfrequenz erfolgen. Dies wird deutlich, wenn man den Betrag der Phasenstellung in zwei Summanden zerlegt, von denen der erste gleich einem ganzzahligen Vielfachen von $2\pi$ und der zweite $\leq 2\pi$ ist. Wegen der Periodizität kann der erste durch den Wert 0 ersetzt werden, ohne dass sich dabei etwas an der Frequenzverschiebung ändert. Es ist also ausreichend, wenn nur der zweite Summand, der Teilerrest, der bei der Division des 'formal richtigen' Phasenwertes durch $2\pi$ entsteht (üblicherweise als Phasenwert 'modulo $2\pi$' bezeichnet), zur Phasenstellung verwendet werden.

Dies hat auch Konsequenzen für Frequenzverschiebungen, deren Betrag genau einem ganzzahligen Vielfachen der Repetitionsfrequenz entspricht, wo also der Frequenzkamm in sich übergeht (abgesehen von der, hier vernachlässigbaren, Amplitudenänderung, die von der viel schwächer frequenzabhängigen spektralen Einhüllenden des Frequenzkamm stammt). Hier ist der Phasenfortschritt $\Delta\varphi_S$, also die Differenz aufeinander folgender Phasenstellungen, gleich einem Vielfachen von $2\pi$ und kann deshalb durch den Wert 0 ersetzt werden.

Physikalischer Hintergrund

Ein Frequenzkamm wird beispielsweise mittels eines modengekoppelten Lasers hergestellt, beispielsweise einem Kerr-Linsen-modengekoppelten Titan-Saphir-Laser. Dieser gibt ein Lichtfeld ab, das im Zeitbild als Modulation einer Trägerschwingung mit einer Trägerfrequenz $v_c$ durch eine periodische, komplexwertige Einhüllende $\hat{E}(t)$ erhalten beschrieben werden kann:

$$E(t) = \sum_n \hat{E}(t - n\tau)\exp\left(i\left\{2\pi v_C(t - n\tau) + n\Delta\varphi_{CE}\right\}\right). \qquad \text{Formel 1}$$

mit der Zeit t, einem Laufindex $n = 0, 1, 2, 3, \ldots$ und der inversen Repetitionsfrequenz

$$\tau = \frac{l_{RES}}{v_g}, \qquad \text{Formel 2,}$$

wobei $l_{RES}$ die Länge des Laseresonators und $v_g$ die Gruppengeschwindigkeit des Lichts im Resonator bezeichnet. $\varphi_{CE}$ ist die sog. *carrier-envelope*-Phase, also die Phasendifferenz der Trägerschwingung zwischen einem charakteristischem Zeitpunkt der Einhüllenden (etwa dem Impuls-Maximum) und einem charakteristischem Zeitpunkt der Trägerschwingung (etwa das Maximum der positiven Halbwelle). Diese Phasendifferenz ist eine Folge des (in aller Regel nicht verschwindenden) Unterschieds zwischen Phasengeschwindigkeit $v_p$ und Gruppengeschwindigkeit $v_g$ des Lichts. Für den Fortschritt der *carrier-envelope* Phase $\Delta\varphi_{CE}$ gilt

$$\Delta\varphi_{CE} = 2\pi\left(\frac{1}{v_g} - \frac{1}{v_p}\right)l_{RES}\,v_c \qquad \text{Formel 3}$$

mit $\nu_C$= optische Trägerfrequenz.

Im Frequenzbild ist das Spektrum darstellbar durch

$$\tilde{E}(\nu) = \tilde{\tilde{E}}(\nu - \nu_c) \sum_m \delta\left(\nu - \frac{\Delta\varphi_{CE}}{2\pi\tau} - \frac{m}{\tau}\right), \qquad \text{Formel 4}$$

d.h. durch eine (komplexwertige) spektrale Einhüllende, gegeben durch die Fouriertransformierte der zeitlichen Einhüllenden, multipliziert mit einem Dirac-Kamm, d.h. einer Summe von äquidistanten Diracschen Deltafunktionen. Die spektralen Positionen der einzelnen Kammlinien im Spektrum erfüllen

$$\nu_m = \frac{\Delta\varphi_{CE}}{2\pi\tau} + \frac{m}{\tau}, \qquad \text{Formel 5}$$

was mit der carrier-envelope-offset- (CEO-) Frequenz $\nu_{CEO} = \dfrac{\Delta\varphi_{CE}}{2\pi\tau}$ und der Definition der Repetitionsfrequenz $f_{REP}=1/\tau$

$$\nu_m = \nu_{CEO} + m f_{REP} \qquad \text{Formel 6}$$

entspricht.

Zur Erläuterung kann angenommen werden, dass die Parameter des Frequenzkamms perfekt stabilisiert sind, dass also von den drei Größen, die ihn charakterisieren (Repetitionsfrequenz $f_{REP}$, optische Trägerfrequenz $\nu_C$ und CEO-Frequenz $\nu_{CEO}$) mindestens zwei auf das Ausgangssignal einer, als ideal angenommenen, Atomuhr stabilisiert sein könnten. Im Fall der CEO-Frequenz könnte die Stabilisierung auch auf den Wert 0 erfolgen, wofür dann keine Atomuhr erforderlich ist. Eine derartige Stabilisierung ist jedoch, wie weiter unten gezeigt wird, nicht zwingend erforderlich.

Dieser Frequenzkamm wird in einem ersten Schritt (i) wohldefiniert frequenzverschoben. Mit dem verschobenen Frequenzkamm wird in einem zweiten Schritt (ii) die Frequenz und Phase der Emission einer zweiten Quelle phasenverfolgbarer Strahlung, hier Arbeits-Lichtquelle genannt, geregelt, so dass sich deren Frequenz sprungfrei und kontinuierlich innerhalb des Frequenzkammes abstimmen lässt.

Die Robustheit dieser Phasenregelung und die erlaubte Frequenzänderungsgeschwindigkeit der Arbeits-Lichtquelle kann erhöht werden, indem $\nu_{SL}$ durch eine Frequenz-Vorstabilisierung grob auf einen Vorwert eingestellt wird, der nicht weiter als einen Bruchteil (z. B. 25%) der Repetitionsfrequenz vom gewünschten Sollwert entfernt liegen sollte. Diese Frequenzvoreinstellung der Arbeitslichtquelle lässt sich auf verschiedene Weise erreichen. Die einfachste Methode ist das *feed-forward,* also eine Steuerung bei dem die *Stellgröße* nicht genau proportional zur *Führungsgröße* sein muss. Hier wird in Vorversuchen eine Kalibrierkurve erzeugt und in einer *look-up*-Tabelle abgespeichert. Diese Kalibrierkurve gibt an, welche Spannung am Frequenz-Steuereingang der Arbeits-Lichtquelle zu welcher Arbeits-Frequenz führt.

Eine andere Möglichkeit ist die Frequenzregelung mittels eines unbeschränkten interferometrischen Frequenzdiskriminators. Er besteht zum Beispiel aus einem Heterodyn-Interferometer mit einer stabilen Weglängendifferenz. Das Heterodyn-Interferometer wird mit dem Licht der Arbeits-Lichtquelle betrieben. Jede Frequenzänderung der Arbeits-Lichtquelle wird vom Frequenzdiskriminator in eine Phasenänderung des elektronischen Heterodyn-Schwebungssignals konvertiert. Anders ausgedrückt: bei Vorgabe einer *Führungsgröße* in Form der Phasenverschiebung zwischen Heterodyn-Treiber- und -Schwebungssignal (diesmal nicht modulo-2π!) wird diese im geschlossenen Regelkreis in die *gesteuerte Größe* Trägerfrequenz konvertiert. Es gibt mehrere Realisierungsmöglichkeiten für derartige unbeschränkte elektronische Phasenschieber.

Es ist anzumerken, dass der beschriebene Phasen-Regelungsprozess absolut eindeutig ist. Wegen der angenommenen stabilen Kammparameter gibt es für jeden Impuls genau eine richtige Phasenstellung modulo 2π. Diese 2π-Mehrdeutigkeit kommt aber nicht zum Tragen, weil durch die Frequenz-Vorstabilisierung die *Regeldifferenz* des Phasenregelkreises bei jedem Impuls bereits viel kleiner ist als 1 rad und durch die Regelung nach Schritt ii) weiter verkleinert wird. Es wird dabei das so genannte *aliasing,* ein normalerweise unerwünschter Effekt beim Abtasten periodischer Signale, vorteilhaft ausgenutzt:

Wie bereits ausgeführt, kann durch den Modulo-$2\pi$-Effekt die Phasenstellung im Phasen-Stellglied immer kleiner als $2\pi$ bleiben, selbst wenn die Arbeits-Frequenz um beispielsweise $10^5$ Kammlinienabstände verschoben wird. Dadurch bleibt die benötigte Steuerspannung des Phasen-Stellglieds, beispielsweise eines elektro-optischen Modulators, relativ klein. Sie kann bei unter 10 Volt bei typischen Wellenleiter-Modulatoren liegen. Dadurch wird die Frequenz/Phasen-Steuerung auch bei hochrepetierlichen ($f_{rep}$>10 MHz) Systemen möglich.

Vorteilhaft an der Erfindung ist, dass die Arbeits-Frequenz schnell und phasenstetig auf beliebige Werte innerhalb der Kammbreite eingestellt werden kann und dabei jederzeit auf die Basiseinheit Sekunde rückführbar ist. Vorteilhaft ist zudem, dass auch komplizierte, großhubige Modulationszyklen durchführbar sind. Die Anzahl der Trägerzyklen (z. B. $10^{14}$) während des Modulationszyklus ist stets eindeutig bekannt.

Die Erfindung ist anwendbar in Verfahren zur selektiven Zustandspräparation in Atomen/Molekülen mit komplizierten Termschemata. Die Erfindung ist auch in LIDAR *(light detection and ranging)*-Verfahren anwendbar. Bei einem solchen Verfahren wird eine streng zeitlineare Frequenzrampe des optischen Feldes durch Zweistrahlinterferenz in ein schmalbandiges HF-Feld umgesetzt, dessen Frequenz proportional zum Weg ist und dann im Prinzip mit der Genauigkeit einer Atomuhr gemessen werden kann. Hier wird also die Basiseinheit Meter definitionsgemäß realisiert.

Vorzugsweise wird zum Erzeugen des Arbeits-Lichts eine aktive, kontinuierliche Licht-Quelle verwendet, die ein phasenkohärentes Emissionsfeld erzeugt. Besonders bevorzugt wird eine Extended-Cavitiy-Laserdiode (ECL, Mikroresonator-Laser-Diode).

Die abstimmbare Arbeits-Lichtquelle kann einen Resonator umfassen, der beispielsweise mit einer Temperaturregelung verbunden ist, so dass er durch das Einstellen der Temperatur in seiner Resonanz-Frequenz einstellbar ist. Alternativ ist es möglich, dass der Resonator eine piezo-mechanische Verstellvorrichtung umfasst, mittels der seine Länge und damit die Resonatorfrequenz einstellbar ist.

Alternativ kann die Arbeits-Lichtquelle aus einem passiven Resonator bestehen, dessen Speicherzeit deutlich länger als der Impulsabstand ist (d. h. dass die Resonanzbreite viel kleiner als der Kammlinienabstand ist). Die Phasenkopplung sollte dann nicht mehr wie bei der nachfolgend beschriebenen Phasenregelung *in Quadratur* erfolgen, sondern statt dessen *in Phase.* Das kann z. B. mittels des sog. Hänsch-Couillaud-Verfahrens erfolgen. Auf diese Weise lässt sich eine optisch-passive phasenkohärente Lichtquelle realisieren, deren modensprungfreier Abstimmbereich größer ist als bei allen bekannten Lichtquellen mit phasenkohärenten Emissionsfeldern (Laser oder optischparametrischen Oszillatoren, OPOs). Der Abstimmbereich ist hier im Prinzip nur durch den spektralen Reflexionsbereich der Resonatorspiegel begrenzt.

Vorzugsweise umfasst das erfindungsgemäße Verfahren den zusätzlichen Schritt des Auskoppelns von Licht mit der Soll-Frequenz.

Gemäß einer bevorzugten Ausführungsform werden die Änderungen der Phasenstellung zu Änderungs-Zeitpunkten durchgeführt, die einen zeitlichen Abstand voneinander von höchstens einer Inversen der Repetitionsfrequenz der Einhüllenden haben.

Vorzugsweise werden die Phasen des ggf. verschobenen Frequenzkammfeldes und des ggf. verschobenen Emissionsfeldes der Arbeits-Lichtquelle gekoppelt. Bei der Kopplung können eine oder mehrere zusätzliche, vorgebbare Heterodyn-Offsetfrequenzen $\nu_{Het}$ berücksichtigt werden.

Vorzugsweise wird die Arbeits-Lichtquelle so geregelt, dass das Licht der Arbeits-Lichtquelle und das Licht der Kammlinie unter Einschluss der Frequenz-Verschiebung eine feste Phasenbeziehung haben. Hierzu kann beispielsweise eine optische Phasenregelung verwendet werden.

Vorzugsweise wird die Arbeitsfrequenz so voreingestellt, dass sich ihr Wert um weniger als 25 % der Repetitionsfrequenz von der Soll-Frequenz unterscheidet

Erfindungsgemäß ist zudem ein Verfahren, wie es oben beschrieben wurde, bei dem für das Licht ein sich mit der Zeit ändernder Wert der Soll-Frequenz vorgegeben wird. Die Zeitabhängigkeit dieses Wertes wird Frequenzverlauf genannt. Der Frequenzverlauf wird dadurch erzeugt, dass die Phasenstellungsfortschritte $\Delta\varphi_S$ mit der Zeit verändert werden.

Bei dem Phasen-Stellglied kann es sich um einen elektro-optischen Modulator (EOM) handeln. Alternativ kann auch ein akusto-optischer Modulator (AOM) eingesetzt werden. Vorzugsweise umfasst der Frequenz-Synthesizer eine Auskoppelvorrichtung zum Auskoppeln von Licht mit der Sollfrequenz.

Bevorzugt ist das Phasen-Stellglied eingerichtet zur zeit-diskreten Veränderung der Phasenstellung mit einem zeitlichen Abstand von höchstens einer Inversen der Repetitionsfrequenz der Einhüllenden. Derartig schnelle Änderungen von Phasenstellungen bewirken, wie oben gezeigt, eine Frequenzverschiebung beispielsweise des Frequenzkamms oder der Frequenz der Arbeits-Lichtquelle, die für die Regelung relevant ist.

Eine einfache Überlegung zeigt, dass es für das Funktionieren der Erfindung irrelevant ist, ob der Frequenzkamm in seiner Frequenz verschoben, die Frequenz des Arbeitslichts darauf durch Phasenkopplung abgestimmt und dann als nutzbares Ausgangsfeld herausgeführt wird, oder ob der Frequenzkamm unverändert bleibt und das Arbeits-Licht (mit dem entgegengesetzten Vorzeichen) frequenzverschoben und dann durch Phasenkopplung auf die Frequenz einer Kammlinie geregelt wird. In diesem Fall muss als nutzbares Ausgangsfeld das Arbeits-Licht vor der Frequenzverschiebung herausgeführt werden. In beiden Fällen entspricht die Frequenz des herausgeführten Ausgangsfeldes der vorgegebenen Soll-Frequenz.

Vorzugsweise weist die Frequenzkamm-Lichtquelle zumindest einen frequenzstabilisierten Oszillator auf, insbesondere eine stabilisierte optische Strahlungsquelle und/oder eine stabilisierte Mikrowellen-Strahlungsquelle. Auf diese Weise sind die Versatz-Frequenz (Carrier-Envelope-Offset-Frequenz) $\nu_{CEO}$ und/oder die Repetitionsfrequenz $f_{REP}$ mit hoher Genauigkeit bekannt, so dass auch der Wert der Arbeits-Frequenz mit hoher Genauigkeit auf den Zielwert eingestellt werden kann.

Im Folgenden wird die Erfindung anhand exemplarischer Ausführungsbeispiele mit Bezug auf die beigefügten Zeichnungen näher erläutert. Dabei zeigt

Abb. 1      eine schematische Ansicht eines Frequenzkamms im Zeitbild

Abb. 2      den Frequenzkamm nach Abb. 1 im Frequenzbild,

Abb. 3a      den vereinfachten Wirkungsplan einer Steuerung (nach DIN 19226),

Abb. 3b      die Phasensteuerung eines optischen Feldes mittels digitaler Führungsgröße,

Abb. 3c      die phasenstarre Frequenzsteuerung der Spektrallinien $E_m$ eines Frequenzkamms mittels digitaler Führungsgrößen (wobei das eingezeichnete Phasenstellglied Abb. 3b entspricht),

Abb. 4a      den vereinfachten Wirkungsplan einer Regelung (nach DIN 19226),

Abb. 4b      den Wirkungsplan einer optischen Homodyn-Phasenregelung im eingerasteten Zustand,

Abb. 4c      einen Frequenz-Generator, der eine Frequenzkamm-Lichtquelle und einen optischen Frequenzsynthesizer mit phasenstarrer Frequenzsteuerung als Kombination von Phasensteuerung nach Abb. 3b, Frequenzsteuerung nach Abb. 3c und Phasenregelung nach Abb. 4b umfasst,

Abb. 5a      ein schematisches Schaltbild eines erfindungsgemäßen Frequenz-Generators zum Durchführen eines erfindungsgemäßen Verfahrens,

Abb. 5b      ein Schema einer zweiten Ausführungsform eines erfindungsgemäßen optischen FrequenzGenerators,

Abb. 6      den zeitlichen Verlauf der vom Phasen-Stellglied erzeugten Phasenstellungen $\varphi_S$ (44), die zu einer konstanten Frequenzverschiebung (d.h. zu einem konstanten Phasenfortschritt pro Zeiteinheit (Kurve 46)) führt und

Abb. 7      ein Beispiel für die zeitliche Entwicklung der Phasenstellung $\varphi_S$ des Phasen-Stellglieds 36 (Kurve zwischen 0 und $2\pi$), die zum eingezeichneten Frequenz-Abstimmprozess (durchgezogene Linie) des Arbeitslichtes führt.

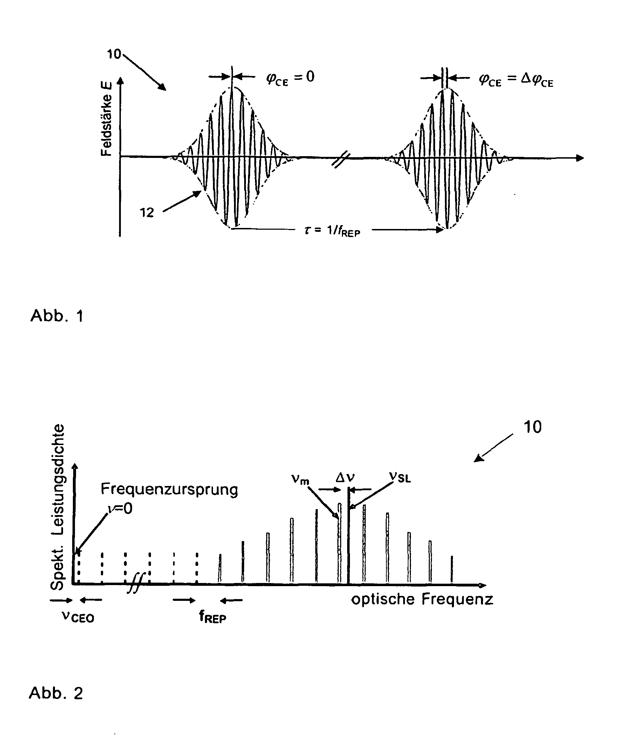

Abb. 1 zeigt schematisch einen Frequenzkamm 10 im Zeitbild, das heißt, dass die elektrische Feldstärke E über der Zeit t aufgetragen ist. Ein derartiger Frequenzkamm 10 ist beispielsweise durch einen Kerr-Linsen-Modengekoppelten Titan-Saphir-Laser erhaltbar. Der Frequenzkamm 10 kann beschrieben werden durch Modulation einer Trägerschwingung mit der Trägerfrequenz $\nu_C$ durch eine im allgemeinen Fall komplexwertige Einhüllende 12 mit einer Repetitionsfrequenz $f_{REP}$. Hier wurde beispielhaft eine rein reelle Einhüllende (Amplitudenmodulation in Form kurzer Impulse) angenommen.

Abb. 2 zeigt den Frequenzkamm 10 im Frequenzbild, wobei die Leistungsdichte des jeweiligen spektralen Anteils über der optischen Frequenz $\nu$ aufgetragen ist. Die glockenkurvenförmige Kurve beschreibt beispielhaft die spektrale Einhüllende des kammförmigen Emissionsspektrums. Am linken Ende der Glockenkurve ist der langwellige Spektralbereich, am rechten Ende der kurzwellige. Bei einer streng-zeitperiodischen Modulation, wie in Abb. 1 angenommen, liegen die einzelnen Spektrallinien äquidistant und haben einen Abstand voneinander, der der Repetitionsfrequenz $f_{REP}$ entspricht. Der Frequenzkamm wurde bis zum Frequenzursprung extrapoliert (gestrichelte Linien). Beginnend bei der der (fiktiven) ersten Kammlinie mit positiver Frequenz (der CEO-Frequenz) wird jeder Kammlinie eine ganzzahlige Ordnungszahl m zugewiesen.

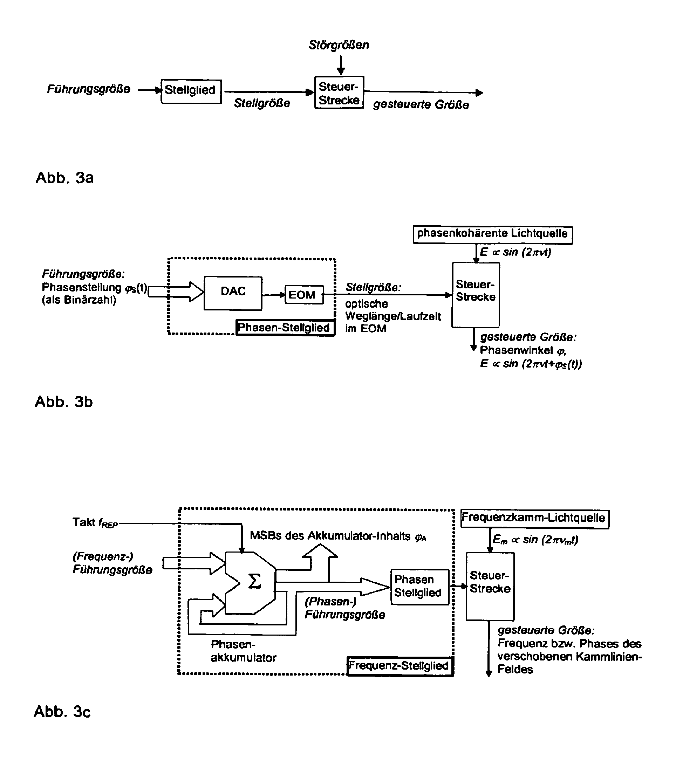

Die Phasen- bzw. Frequenz-Steuerung zur Frequenzverschiebung der Kammlinien wird in Abb. 3 erläutert wird. Abb. 3a führt die verwendeten Begriffe ein. Abb. 3b zeigt eine Ausführungsform einer optischen Phasensteuerung, wobei die die *(Phasen-)Führungsgröße* [Phasenstellung $\varphi_S(t)$] digital, d. h. in Form einer Binärzahl vorliegt. Diese Binärzahl wird in eine (analoge) elektrische Spannung gewandelt, die den Brechungsindex eines elektro-optischen Modulators beeinflusst und somit als *Stellgröße* [Laufzeit- bzw. Weglängen-Änderung] die Phase eines Lichtfeldes verändert, das von einer phasenkohärenten Lichtquelle stammt. Wenn nun, wie in Abb. 3c gezeigt, eine Frequenzkamm-Lichtquelle eingesetzt und der Wert dieser *(Phasen-)Führungsgröße* im Takt der Repetitionsfrequenz $\tau=1/f_{REP}$ um $\Delta\varphi_S(t)$ verändert wird, so wird die Frequenz jeder Kammlinie um den Wert

$$\Delta\nu = \frac{\Delta\varphi_S(t)}{2\pi\tau}, \quad \tau = \frac{1}{f_{REP}}$$

verändert. Es gilt also

$$E_m \propto \sin(2\pi\nu_m t + \frac{\dot{\varphi}_S(t)}{\tau}t) \ .$$

Diese Änderung der *(Phasen-)Führungsgröße* der Phasensteuerung nach Abb. 3b kann z. B., wie in Abb. 3c gezeigt, mit Hilfe eines sog. Phasenakkumulators erfolgen. Hier wird nach jedem Zeitintervall reine Binärzahl, nämlich der binäre Wert $\Delta\varphi_S$ zum aktuellen Inhalt des Phasenakkumulators (dessen Wert hier mit $\varphi_A$ bezeichnet wird) addiert. Die niederwertigen Bits des Akkumulator-Ausgangs werden als *(Phasen-)Führungsgröße* der Phasensteuerung nach Abb. 3b verwendet. Ihre Anzahl muss groß genug sein um ein Winkelintervall der Breite $2\pi$ abzudecken. Diese niederwertigen Bits zeigen, zusammen mit den höherwertigen Bits (MSBs), bei eingerasteter Phasenregelung die aktuelle Phasendifferenz zwischen dem Arbeitslichtfeld und dem Feld der (unverschobenen) m-ten Kammlinie, sofern der Akkumulatorinhalt $\varphi_A$ zu Beginn des Abstimmprozesses auf den Wert 0 gesetzt wurde.

Abb. 3c zeigt somit eine Frequenzsteuerung, bei der die *Führungsgröße*

$$2\pi\Delta\nu(t) = \frac{\Delta\varphi_S(t)}{\tau}$$

nach der Steuerstrecke auf die (phasenstarr) *gesteuerte Größe* [Phase des Feldes der verschobenen m-ten Kammlinie]

$$2\pi(\nu_m + \Delta\nu) = 2\pi(\nu_m + \frac{\Delta\varphi_S(t)}{2\pi\tau}) \ .$$

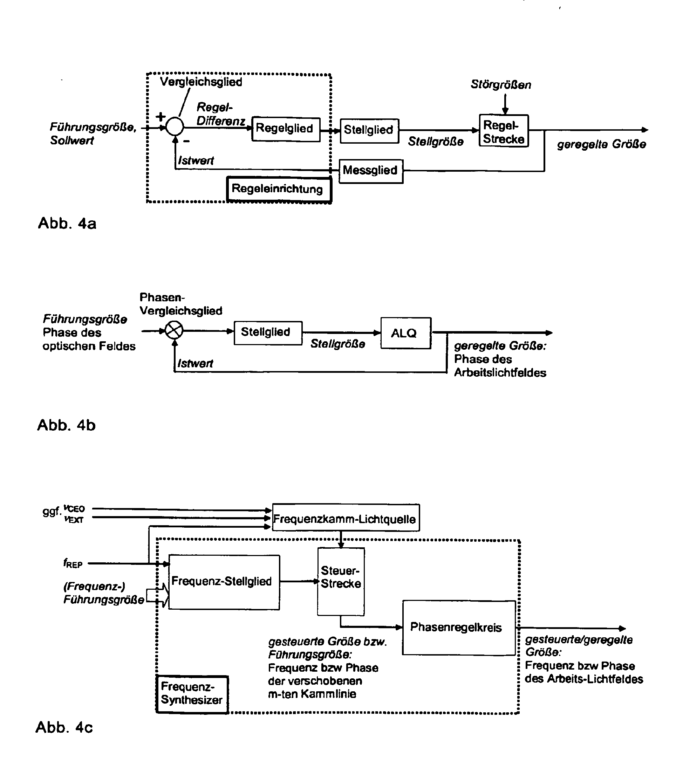

abgebildet wird. Diese dient als *Führungsgröße* für die Phasenregelung der Arbeitslichtfrequenz, wie in Abb. 4b gezeigt wird.

Zur Erläuterung stellt Abb. 4a das Grundschema einer einfachen Regelung vor und führt entsprechende DIN-Begriffe ein. Vereinfacht gesagt, wird hier mittels eines Vergleichsglieds der Sollwert der *Führungsgröße* mit dem Istwert der *geregelten Größe* verglichen. Die daraus entstehende Größe, die *Regel-Differenz,* wird geeignet aufbereitet und wirkt als *Stellgröße* mittels der Regelstrecke auf die *geregelte Größe* ein.

Im hier betrachteten Fall eines optischen Phasenregelkreises werden die Phasenwerte der Ausgangsfelder der beiden Lichtquellen, nämlich die Emission des Frequenzkamm-Lichtquelle und das Licht der Arbeits-Lichtquellein mit Hilfe eines Phasen-Vergleichsglieds miteinander verglichen, siehe Abb. 4b. Dabei dient, wie gesagt, die Phase des Feldes der frequenzversetzten m-ten Kammlinie als *Führungsgröße* und die Phase des Arbeitslichtfeldes ist die *geregelte Größe.*

Dieser Vergleich ist immer dann möglich, wenn die beiden Lichtfelder gleichzeitig vorliegen und miteinander interferieren, wenn es also einen räumlichen, spektralen, zeitlichen und Polarisations-Überlapp der Felder gibt.

Durch Rückkopplung der *Stellgröße* auf die Regelstrecke wird somit die *geregelte Größe, d. h.* die Phase des Arbeitslichtfeldes $2\pi\nu_{SL}t$, auf die *Führungsgröße* [Phase des Feldes der frequenzversetzten m-ten Kammlinie] geregelt.

Der Vollständigkeit halber sei angemerkt, dass hier auch ein Heterodyn-Schema eingesetzt werden könnte, bei dem die Phase des (elektronischen) Schwebungssignals zwischen Frequenzkamm (nach dem er mit der Frequenzsteuerung nach Abb. 3c frequenzversetzt wurde) und der Arbeits-Lichtquelle AQL auf ein Hochfrequenz-Referenzsignal mit einer Heterodyn-Frequenz $\nu_{Het} \neq 0$ geregelt wird. Vorteilhaft daran sind die Unempfindlichkeit gegenüber Streulicht, die Möglichkeit zum automatisierten Übergang von der Frequenz- zur Phasenregelung und zur Vorteilung der Schwebungsfrequenz (*wide-angle phase-locking*) im Interesse eines vergrößerten Dynamikbereichs.

Die Kombination der phasenstarren Frequenzsteuerung nach Abb. 3c und der optischen Phasenregelung nach Abb. 4b ergibt einen optischen Frequenz-Synthesizer 18, der zusammen mit der Frequenzkamm-Lichtquelle 16 den erfindungsgemäßen Frequenz-Generator bildet.

Analog zu einem Radiofrequenz-Synthesizer besitzt der optische Frequenz-Synthesizer 18 einen (z. B. digitalen) Eingang für den Sollwert der Ausgangsfrequenz und einen Eingang für die Referenzfrequenz(en). Wie unten ausgeführt können dies zwei der Größen $f_{REP}$, $\nu_{EXT}$ und/oder $\nu_{CEO}$ sein.

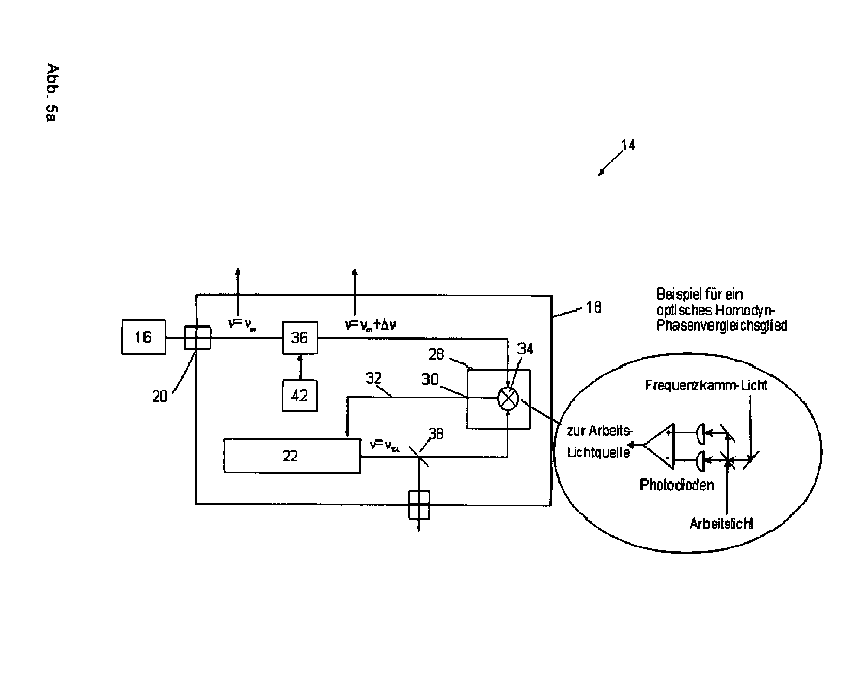

Abb. 5a zeigt einen erfindungsgemäßen Frequenz-Generator 14, der eine Frequenzkamm-Lichtquelle 16 und einen erfindungsgemäßen Frequenz-Synthesizer 18 umfasst, dessen Komponenten mit einem gestrichelten Rechteck umgeben sind. Die Frequenzkamm-Lichtquelle 16 umfasst z.B. einen Femtosekunden-Laser, dessen Emissionsparameter auf eine feste und bekannte Relation zur Frequenz einer nicht eingezeichneten optischen Atomuhr festgelegt sein können. Der Frequenz-Generator 14 ist mit einem Lichteingang 20 des Frequenz-Synthesizers 18 verbunden, so dass das Lichtfeld 10 der Frequenzkamm-Lichtquelle 16 einspeisbar ist.

Der Frequenz-Synthesizer 18 umfasst eine Arbeits-Lichtquelle 22, beispielsweise in Form einer Laserdiode mit externem Resonator, wobei der Resonator in seiner Resonator-Frequenz veränderbar ist. Die Arbeits-Lichtquelle 22 gibt Arbeits-Licht 24 mit einer Arbeits-Frequenz $\nu_{SL}$ ab. Das Arbeits-Licht wird auf einen Eingang einer Regeleinrichtung 28 geleitet. Die Regeleinrichtung besitzt zwei Eingänge für Lichtfelder und umfasst ein Phasen-Vergleichsglied 34, das die Phasen der Eingangsfelder vergleicht und eine *Regel-Differenz* 30 ausgibt. Mittels einer Signalübertragungsvorrichtung 32 wird diese *Regel-Differenz* (nach geeigneter Signalaufbereitung in einem Regelglied) zur Stellung der Arbeits-Frequenz an die Arbeits-Lichtquelle 22 abgegeben.

Zu dem zweiten Eingang der Regeleinrichtung 28 wird das Feld aus der Frequenzkamm-Lichtquelle geleitet, das das Phasen-Stellglied 36 durchlaufen hat. Dazu ist das Phasen-Stellglied 36 mit dem Lichteingang 20 verbunden.

Ein einfaches Beispiel für ein optisches Phasen-Vergleichsglied 34, das das sogenannte Homodyn-Schema verwendet, wird ebenfalls in Abb. 5a gezeigt. Hier werden beide optischen Felder mit einem 50:50 Spiegel überlagert und die überlagerten Felder an seinen beiden Ausgängen mit zwei Photodioden detektiert. Anschließend wird die Differenz ihrer Photoströme gebildet. Diese elektrische *Regeldifferenz* hat genau dann ihren Nulldurchgang, wenn sich die Phasen der beiden optischen Felder bei ihrer Überlagerung in Quadratur befinden. Die *Regeldifferenz* ist (im Kleinsignalfall) proportional zur Abweichung von dieser Quadraturposition. Durch Rückkopplung auf die Regelstrecke (indem z. B. mittels eines Piezo-Verstellers die *Stellgröße* [Resonatorlänge der Arbeitslichtquelle 22] beeinflusst wird) wird *die geregelte Größe* auf die *Führungsgröße* geregelt.

Bei dem Phasen-Stellglied 36 handelt es sich z. B. um einen elektro-optischen Modulator oder einen akustooptischen Modulator, beispielsweise um einen integrierten Wellenleiter-EOM.

Im Betrieb wird das folgende Verfahren durchgeführt. Mit Hilfe der Arbeits-Lichtquelle 22 wird das Arbeits-Licht erzeugt. Über den Lichteingang 20 wird der Frequenzkamm 10 in den Frequenz-Synthesizer 18 eingekoppelt. Der Frequenzkamm wird dann mittels des Phasen-Stellglieds 36 zu beispielsweise äquidistanten Zeitpunkten $t_k$ mit $k = 1,2,3, ...$ um diskrete Phasenstellungen $\varphi_S(t_k)$ verschoben. Da die Änderungen der Werte der Phasenstellung schnell aufeinander folgen, entspricht dieser Phasenstellungsfortschritt (gemessen hinter dem Phasen-Stellglied) einer Änderung der Versatz-Frequenz bzw. Carrier-Envelope-Offset-Frequenz $\nu_{CEO}$, wie oben beschrieben ist. Wird beispielsweise die m-te Kammlinie (Frequenz $\nu_m$) betrachtet , so wird diese durch die regelmäßigen diskreten Phasenfortschritte um die Frequenz-Verschiebung $\Delta\nu$ verschoben. Die Arbeits-Lichtquelle 22 wird dann durch die Regeleinrichtung 28 so angesteuert, dass die Arbeits-Frequenz $\nu_{SL}$ (im eingerasteten Zustand der Phasenregelung) gleich der frequenzverschobenen Kammlinien-Frequenz $\nu_{Soll} = \nu_m + \Delta\nu$ wird.

Um die Frequenz der Arbeitslichtquelle auf ihren Sollwert $\nu_{Soll}$ zu regeln, wie in Abb. 5a schematisch eingezeichnet ist, wird zunächst die nächstliegende Kammlinie ermittelt, im vorliegenden Fall mit der Ordnungszahl m. Danach wird das Phasen-Stellglied 36 von einer schematisch eingezeichneten Kontroll-Einrichtung 42, die die phasenstarre Frequenzsteuerung nach Abb. 3c einschließt, so angesteuert, dass die die Frequenz der m-ten Kammlinie, gemessen hinter dem Phasen-Stellglied 36 (also die *gesteuerte Größe* der Frequenzsteuerung), genau den Wert $\nu_{Soll} = \nu_m + \Delta\nu$ hat. Anschließend führt die Kontroll-Einrichtung 42 die Frequenz der Arbeitslichtquelle so dicht an den Wert $\nu_{Soll}$ heran, dass als Folge der Phasenregelung die Phase des Arbeitslichts auf diese *Führungsgröße* einrastet und die Arbeits-Lichtquelle 22 exakt auf der Soll-Frequenz $\nu_{Soll}$ oszilliert.

Ein Teil des Arbeits-Lichtfelds, dessen Frequenzwert dann dem Soll-Frequenzwert entspricht, kann über einen Strahlteiler 38 aus dem FrequenzSynthesizer 18 ausgekoppelt werden.

Soll nun die Soll-Frequenz $\nu_{Soll}(t)$ zeitabhängig werden, so steuert die Kontroll-Einrichtung 42 das Phasen-Stellglied 36 so an, dass die *gesteuerte Größe* [Frequenz der verschobenen Kammlinie] den vorgegebenen, zeitabhängigen Wert $\nu_{Soll}(t)$ annimmt. Wird der Wert der Frequenzverschiebung $\Delta\nu$ größer als der Wert der Repetitionsfrequenz

$f_{REP}$ (dies passiert wenn die Emissionslinie der Arbeitslichtquelle über eine Kammlinie fährt), so werden, wie oben ausgeführt, dennoch keine größeren Phasenstellungsfortschritte als $2\pi$ benötigt.

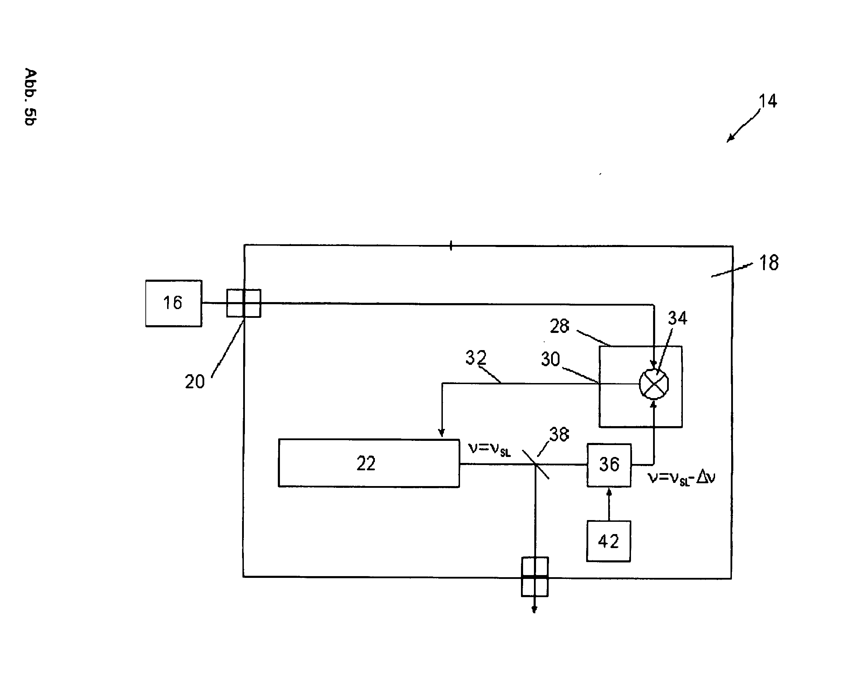

Abb. 5b zeigt eine alternative Ausführungsform eines erfindungsgemäßen Frequenzgenerators 14, bei dem das Phasen-Stellglied 36 zum resonator-externen Verschieben der Arbeits-Frequenz $\nu_{SL}$ der Arbeits-Lichtquelle 22 eingesetzt wird. Hier ist also die Frequenz bzw. Phase der m-ten Kammlinie die *Führungsgröße* für die Phasenregelung des Arbeitslichtfeldes, dessen Frequenzwert durch eine phasenstarre Frequenzsteuerung nach Abb. 3c mit umgekehrten Vorzeichen verschoben wurde.

Das Arbeitslicht wird vor der Steuerstrecke mittels der Auskoppelvorrichtung 38 ausgekoppelt. Analog zu Abb. 5a erfolgen die Änderungen der Phasenstellungen $\varphi_S$ ebenfalls im zeitlichen Abstand $\tau$.

Die Ausführungsformen nach Abb. 5a und 5b können kombiniert werden.

Für spezielle Anwendungen können auch die Rollen des Kammlinienfeldes und des Arbeitslichts vertauscht werden. Dann wird die Trägerfrequenz des Frequenzkamms relativ zu der 'Arbeitslicht'-Frequenz verstimmt. Dies kann, im Prinzip, ebenfalls unbegrenzt durchgeführt werden, also z. B. über Frequenzintervalle, deren Breite ein Vielfaches von $f_{REP}$ beträgt Die CE-Phase wird in diesem Fall auf das Feld der 'Arbeitslichtquelle' (die hier z. B. ein optisches Frequenznormal ist) geregelt, welches die oben beschriebene Frequenz-Steuerstrecke durchlaufen hat.

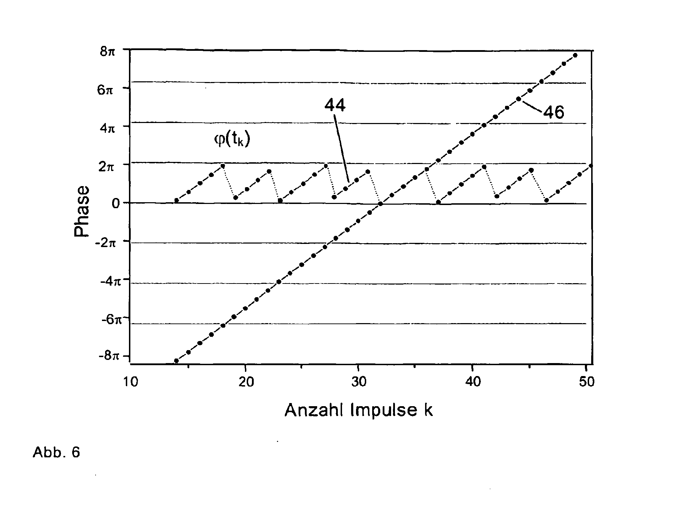

Abb. 6 zeigt als Beispiel eine Kurve 44, die die Phasenstellungen $\varphi(t_k)$ angibt, die vom Phasen-Stellglied 36 zu den diskreten Zeitpunkten $t_k$ eingestellt werden, um eine konstante Frequenzverschiebung $\Delta\nu$ zu erzeugen. Sie zeigt zudem eine zweite Kurve 46, die Zeitentwicklung der Arbeitslicht-Phase relativ zu einem (gedachten) Dauerstrich-Lichtfeld mit der Frequenz $\nu_m$.

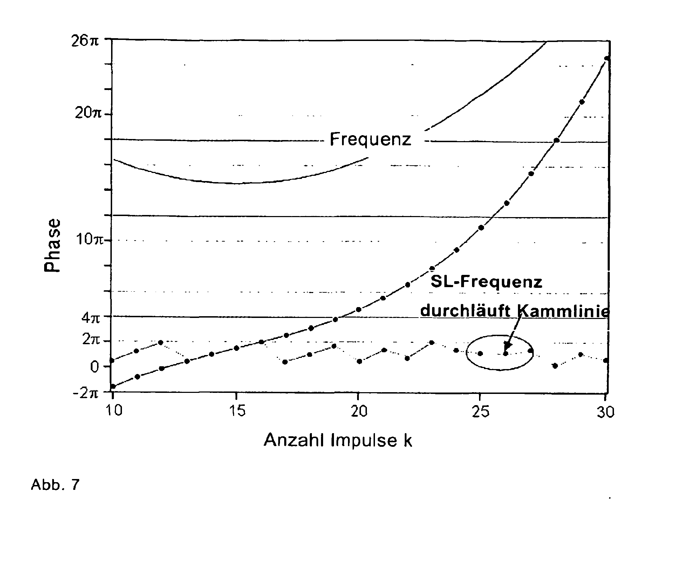

Abb. 7 zeigt beispielhaft entsprechende Kurven für eine Zeitabhängigkeit der Sollfrequenz in Form einer Parabel.

**Aktiver Frequenztransfer zur Stabilisierung ausgewählter Kammlinien**

Zu Beginn dieser Ausführungen wurde ein idealer, stabiler Frequenzkamm angenommen. Dies ist jedoch nicht notwendig, wenn man das sog. Transferkonzept anwendet [H.R. Telle, B. Lipphardt, J. Stenger, "Kerr-lens, mode-locked lasers as transfer oszillators for optical frequency measurements", Appl. Phys. B 74, 1-6 (2002)]. Hier werden 2 der oben genannten 3 Kammparameter laufend gemessen, also beispielsweise die optische Trägerfrequenz und die Repetitionsrate. Diese Messwerte werden bei der Berechnung der Phasenstellungen der einzelnen Impulse berücksichtigt.

Die folgenden Ausführungen beziehen sich auf frei gewählte, aber danach mit fester Ordnungszahl (Laufindex) angenommene Kammlinien. Diese Situation kommt bei der optischen Frequenzmetrologie vor. Nachfolgend werden drei Situationen betrachtet, die von verschiedenen Referenzsignal-Konfigurationen ausgehen:

1) <u>Methode A</u>, ausgehend von einer optischen Schwebung und $\nu_{CEO}$

Es sei ein stabiles optisches Referenzfeld mit der Frequenz $\nu_{EXT}$ vorhanden. Das Referenzfeld wird mit dem Feld des Frequenzkamms überlagert. Mittels einer Photodiode wird die Schwebung mit der nächstliegenden Kammlinie gemessen.

Zur nachfolgenden Beschreibung der Signalverarbeitungsschemata wird von der Kammgleichung $\nu_m = mf_{REP}+\nu_{CEO}$ (Formel 6) ausgegangen. Zur Vermeidung doppelter Indizes (die bei mehreren Ordnungszahlen m auftreten würden) wird ihre Schreibweise folgendermaßen vereinfacht:

$$\nu_X \equiv m_X f_{REP} + \nu_{CEO} \qquad \text{Formel 7}$$

Man erhält dann

$$\begin{aligned}\nu_S &= \nu_{EXT} - \nu_1\\ &= \nu_{EXT} - m_1 f_{REP} - \nu_{CEO}\end{aligned} \qquad \text{Formel 8}$$

als Schwebungsfrequenz. Die Carrier-Envelope-Offset-Frequenz $\nu_{CEO}$ wird gleichzeitig gemessen, etwa mit einem sog. f-2f-Interferometer.

Durch analoge Mischung von $\nu_S$ und $\nu_{CEO}$ wird ihre Summenfrequenz erzeugt. Sie dient als Taktsignal für einen DDS-IC (direct digital synthesis integrated circuit, integrierter Schaltkreis für direkte digitale Synthese), dessen Tuning-Wort so gewählt wird, dass er ein rationales Teilungsverhältnis $m_2/m_1$ realisiert, wobei $m_2$ die Ordnungszahl der zu stabilisierenden Kammlinie ist. Von diesem Signal wird durch analoge Mischung $\nu_{CEO}$ abgezogen, um die Frequenz

$\nu_{\text{CONTROL}}$ des Korrektursignals zu erhalten.

$$\nu_{\text{CONTROL}} \equiv \frac{m_2}{m_1}(\nu_S + \nu_{\text{CEO}}) - \nu_{\text{CEO}} \qquad \text{Formel 9}$$

$$= \frac{m_2}{m_1}\nu_{\text{EXT}} - m_2 f_{\text{REP}} - \nu_{\text{CEO}}$$

Durch Addition dieser Mikrowellenfrequenz zu der Frequenz $\nu_2$ der $m_2$-ten Kammlinie, also etwa durch Frequenzverschiebung mittels eines akusto-optischen Modulators, erhält man

$$\nu_2 + \nu_{\text{CONTROL}} \equiv \frac{m_2}{m_1}\nu_{\text{EXT}} \qquad \text{Formel 10}$$

und damit eine *Führungsgröße* für die nachfolgende Phasenregelung des Arbeitslichts, die nicht mehr von den Parametern $\nu_X, \nu_{\text{CEO}}, f_{\text{REP}}$ des Frequenzkammes abhängt.

2) Methode B, ausgehend von der Messung von $f_{\text{REP}}$ und $\nu_{\text{CEO}}$

Nehmen wir an, dass ein frequenzstabiles Mikrowellenreferenzsignal bei zum Beispiel $f_{\text{MW}} \approx 10\,\text{GHz}$ vorliegt. Es wird die Schwebung mit der entsprechenden Harmonischen der Repetitionsfrequenz gebildet. Ihre Frequenz sei

$$f_0 \equiv f_{\text{MW}} - m_{\text{MW}} f_{\text{REP}} \approx 10\,\text{MHz}. \qquad \text{Formel 11}$$

Die Mikrowellenfrequenz wird digital geteilt und $f_0$ wird digital hochvervielfacht. Für den Faktor $n$ bzw. dem Divisor $1/n$ möge der Einfachheit halber $n = 32$ gelten. Die Differenz der so erhaltenen Frequenzen

$$f_1 = n f_0 - f_{\text{MW}} / n \approx 10\,\text{MHz} \qquad \text{Formel 12}$$

liegt wieder ungefähr bei 10 MHz. Dieses Verfahren wird noch zweimal wiederholt

$$f_2 = n f_1 - f_{\text{MW}} / n \approx 10\,\text{MHz} \qquad \text{Formel 13}$$

und

$$f_3 = n f_2 - f_{\text{MW}} / n \approx 10\,\text{MHz}. \qquad \text{Formel 14}$$

Definiert man die Frequenz

$$f_{\mathrm{EXT}} \equiv f_3 + n^3 \, m_{\mathrm{MW}} \, f_{\mathrm{REP}}$$
$$= (n^3 - n - 1 - 1/n) f_{\mathrm{MW}},$$

Formel 15

so liegt diese im optischen Spektralbereich, das heißt $f_{\mathrm{MW}}$ wurde fiktiv in den optischen Spektralbereich hochmultipliziert und $f_3$ ist die Schwebungsfrequenz zwischen der virtuellen Frequenz $f_{\mathrm{EXT}}$ und der Kammlinie eines fiktiven, $\nu_{\mathrm{CEO}}$-freien Kamms mit der Ordnungszahl $n^3 m_{\mathrm{MW}}$:

$$f_3 = f_{\mathrm{EXT}} - n^3 \, m_{\mathrm{MW}} \, f_{\mathrm{REP}}.$$

Formel 16

Mittels eines DDS-IC (direct digital synthesis integrated circuit, integrierter Schaltkreis für direkte digitale (Frequenz-)Synthese) wird diese Frequenz auf die ausgewählte Kammlinie mit der Ordnungszahl $m_X$ projiziert und, wie oben, $\nu_{\mathrm{CEO}}$ durch Mischung addiert. Man erhält so ein Korrektursignal mit der Frequenz

$$\nu_{\mathrm{CONTROL}} \equiv \frac{m_X}{n^3 m_{\mathrm{MW}}} f_3 + \nu_{\mathrm{CEO}}$$

Formel 17

Analog zu Formel 10 erhält man durch Frequenzverschiebung für die $m_X$-te Kammlinie

$$\nu_X - \nu_{\mathrm{CONTROL}} = \frac{m_X}{n^3 m_{\mathrm{MW}}} f_{\mathrm{EXT}} = \frac{m_X}{n^3 m_{\mathrm{MW}}} (n^3 - n - 1 - 1/n) f_{\mathrm{MW}}.$$

Formel 18

Die Frequenz dieser (um den Wert $\nu_{\mathrm{CONTROL}}$ frequenz-verschobenen) Kammlinie entspricht somit einem nicht-ganzzahligen Vielfachen der Mikrowellen-Referenzfrequenz und wird, wie oben, unabhängig von den Parametern des Frequenzkamms.

3) <u>Methode C</u>, ausgehend von der Messung eines optischen Schwebungsignals und $f_{\mathrm{REP}}$

Dieses Schema ist weniger vorteilhaft, weil es sowohl eine optische als auch eine Mikrowellen-Referenzfrequenz benötigt. Ausgehend von Formel 16 erhält man für das Korrektursignal mit der Frequenz

$$\nu_{\mathrm{CONTROL}} \equiv \Delta \nu - \frac{m_2 - m_1}{n^3 m_{\mathrm{MW}}} f_3$$
$$= \nu_{\mathrm{EXT}} - m_2 f_{\mathrm{REP}} - \nu_{\mathrm{CEO}} - \frac{m_2 - m_1}{n^3 m_{\mathrm{MW}}} f_{\mathrm{EXT}}$$

Formel 19

und die die Frequenz der $m_2$-ten Kammlinie wird nach

$$\nu_2 + \nu_{\mathrm{CONTROL}} = \nu_{\mathrm{EXT}} - \frac{m_2 - m_1}{n^3 m_{\mathrm{MW}}} f_{\mathrm{EXT}}$$

Formel 20

verschoben und dadurch wiederum unabhängig von den Frequenzkammparametern.

**Ausführung der Phasen/Frequenz-Steuerung**

Wie oben ausgeführt, bleibt die benötigte Phasenstellung am EOM bevorzugt kleiner als $2\pi$. Eine konstante Frequenzverschiebung, also eine zeitlineare Rampe der Phasenstellung, würde somit sägezahnförmig in viele kleine Rampen aufgeteilt. Zur einfachen Realisierung derartiger modulo-$2\pi$-Rampen eignen sich NCO-(numerically controlled oscillator)-ICs. Bei einem NCO handelt sich um den digitalen Teil eines DDS -(direct digital synthesis)-ICs. Die meisten modernen Ausführungen, sog. *complete DDS,* kombinieren den Digital- und Analogteil in einem Gehäuse und es wird nur die analoge Kurvenform (meist Sinus/Kosinus) am Ausgang bereitgestellt. Es gibt jedoch einige, meist ältere, ICs dieser Art, bei denen die höchsten Bits ihres Phasenakkumulators nach außen geführt sind. Dies ist z. B. beim IC *Q2240I-3S1* der Firma Qualcomm der Fall. Dieser Baustein besitzt eine *tuning-word*-Breite von 32 Bit und eine maximale Taktfrequenz von 100 MHz (bei 5 V Versorgungsspannung). Das 31 Bit breite nutzbare *tuning-word* (TW) wird hier parallel eingelesen, wobei das Bit 32 (das MSB) hardwaremäßig auf 0 gesetzt wird damit die Nyquist-Bedingung erfüllt wird. Die oberen 14 Bit des Phasenakkumulators liegen parallel (alternativ zum Inhalt der internen Sinus-*look-up*-Tabelle) am Ausgang an.

Hiervon können, im Prinzip, die 13 niederwertigen Bits zum Ansteuern eines DAC (*digital-to-analog-converter*) verwendet werden. (Das höchste Bit kann ja, wie gesagt, nicht durch das TW gesetzt werden). In der Praxis ist es sicher ausreichend, nur die oberen 8 Bits davon zu verwenden. Dies führt zu einer Phasenauflösung von 25 mrad was in den allermeisten Fällen mehr als ausreichend sein sollte. Ein Wert von 6 Bit bzw. 0,1 rad wäre für viele Anwendungen auch noch in Ordnung. Man stellt nun das Übertragungsmaß zwischen DAC und EOM so ein, dass die 8 Bit, also der Binärzahlenbereich zwischen 0000 0000 und 1111 1111 am DAC-Eingang, einer Phasenverschiebung von $2\pi$ entsprechen und taktet das IC mit der Repetitionsfrequenz. Dann wird der o.g. modulo-$2\pi$-Phasenfortschritt automatisch erfüllt. Das TW des NCOs bestimmt dann (in binären Einheiten) den optischen Frequenzoffset des SL von einer Kammlinie (immer mit dem selben Vorzeichen gemessen, also z. B. relativ zur niederfrequenten Linie). Ein Wert von

TW1=0000 0000 0000 0000 0000 0000

bedeutet etwa, dass die SL-Frequenz genau mit einer Linie des unverschobenen Frequenzkamms übereinstimmt und

TW2=0100 0000 0000 0000 0000 0000

führt zu einer Frequenz genau in der Mitte zwischen zwei Kammlinien. Bei

TW3=0111 1111 1111 1111 1111 1111

hat man dann fast die nächste Kammlinie erreicht und nach Vergrößerung um ein LSB hat man bei

TW4=(1)000 0000 0000 0000 0000 0000

exakt die nächste Linie erreicht. Der Phasenstellungsfortschritt beträgt jetzt stets $2\pi$, d. h. das DAC-Eingangswort bleibt konstant. Das MSB wird ja, wie gesagt, hardwaremäßig auf 0 gesetzt, d. h. die (1) wird durch eine 0 ersetzt. $TW_4$ ist somit identisch mit $TW_1$.

Abb. 6 verdeutlicht den Sachverhalt am Beispiel einer festen Frequenzverschiebung, d. h. bei einem zeitlinearen Phasenfortschritt. Durch den genannten Überlauf im NCO-Akkumulator erhält man am DAC-Ausgang ein unregelmäßiges Sägezahnsignal, das z. B. mit 6 oder 8 Bit Auflösung quantisiert ist.

Zur Frequenzänderung wird das TW durch eine Steuereinheit (z. B. Rechner) gesetzt, wobei die Phasenstellungsfortschritte $\Delta\varphi_S$, d.h. die Sprünge zwischen zwei aufeinander folgenden Werten, deutlich kleiner als 1 rad sein sollten um eine sichere Phasenverfolgung durch die PLL zu gewährleisten. Für $\Delta\varphi_S<0,1$ rad dürfen beispielsweise die Differenzen $\Delta$ der Binärzahlen nicht größer sein als

$\Delta(0,1\text{rad})=0000\ 0010\ 0000\ 0000\ 0000\ 0000.$

Abb. 7 zeigt ein Beispiel für einen Durchstimmprozess. Die Frequenz wurde hier zeitlich parabelförmig verändert, so dass der Wert der Phasenstellung einer kubischen Parabel folgt. Die DAC-Ausgangsspannung ist jetzt völlig unregelmäßig. Etwa bei Impuls Nr. 27 wird die Frequenz einer Linie des unverschobenen Frequenzkamms durchlaufen, der Phasenstellungsfortschritt zwischen zwei Impulsen beträgt hier $2\pi$. Es ist vielleicht bemerkenswert, dass dieser Kammliniendurchlauf keineswegs exakt zum Zeitpunkt eines Impulses erfolgen muss.

Die Frequenzauflösung des optischen Synthesizers wird durch das LSB des TW gegeben. Entsprechend der o. g. Bewertung des Phasenakkumulators werden genau $2^{31}$ Taktzyklen für einen Phasenstellungsfortschritt von $2\pi$ benötigt. Bei einer Repetitionsfrequenz von z. B. $f_{REP}=100$ MHz führt dies zu einer Frequenzauflösung von rund $\Delta\nu=5$ mHz, wohlgemerkt bei einer optischen Trägerfrequenz von z. B. $\nu=200$ THz. Die relative Frequenzauflösung beträgt also

$$\Delta\nu/\nu \cong 2*10^{-16}$$

oder etwa 52 Bit!

Für die Frequenzabstimmbarkeit erscheint als realistische obere Geschwindigkeitsgrenze ein Wert von einen Kammlinienabstand innerhalb eines Zeitintervalls von 8 Impulsen, was einer Verstimmgeschwindigkeit von

$$\Delta v / \Delta t \lesssim 1\,\text{THz/s}$$

entspricht. In Anbetracht der Tatsache, dass bei dem vorgestellten Synthesekonzept der momentane Phasenwert absolut bekannt ist (d. h. nicht modulo-$2\pi$ sondern inklusive der Periodenanzahl ab dem Startzeitpunkt), sind diese Werte mit bislang bekannten Verfahren nicht erreichbar.

**Passive Arbeits-Lichtqelle mit *intra-cavity* Frequenzverdopplung (*second-harmonic-generation,* SHG)**

Oben wurde die Möglichkeit beschrieben, alternativ zu einer aktiven Arbeits-Lichtquelle, mit einem abstimmbaren, leeren Resonator optisch passiv ein phasenkohärentes Dauerstrichsignal zu erzeugen. Ausgedrückt im Frequenzbild würde man hier den gesamten Frequenzkamm durch die beschriebene phasenstarre Frequenz-Steuerung stets so verschieben, dass die Frequenz einer seiner Linien mit der Mittenfrequenz einer der Resonator-Longitudinalmoden übereinstimmt und somit phasenrichtig die entsprechende Oszillation anfacht. Der Nachteil ist die geringe Effizienz; man nutzt nur eine einzige der vielleicht $10^5$ oder $10^6$ Kammlinien.

Dies lässt sich verbessern durch resonator-interne Frequenzverdopplung / Summenfrequenzerzeugung mittels optisch-nichtlinearem Kristall bei Resonanz auf der zweiten Harmonischen. Jetzt können, neben der zweiten Harmonischen einer bestimmten Kammlinie auch die Summenfrequenzsignale aller symmetrisch hierzu angeordneten Kammpaare zum Gesamtsignal beitragen und die Gesamteffizienz steigt beträchtlich. Hier gibt es weitreichende Parallelen zur 2-Photonen-Frequenzkamm-Spektroskopie.

Für die Phasenkopplung des internen frequenzverdoppelten Feldes an das Anregungsfeld durch Längenregelung des Resonators könnte man einen Phasenvergleich ähnlich wie beim *Hänsch-Couillaud*-Verfahren verwenden: der durch den Resonator transmittierte Anteil der Fundamentalwelle wird durch eine (achromatische) $\lambda/2$-Platte um 90° in seiner Polarisation gedreht und auf einen zweiten, resonator-externen Verdopplerkristall geschickt. Da das parallel dazu aus dem Resonator austretende SH-Licht nicht in seiner Polarisation gedreht wird (die lambda/2-Platte ist hier eine $\lambda$-Platte!), stehen die Polarisationsrichtungen der beiden SH-Signale senkrecht zueinander und ihre relative Phase kann leicht polarisationstechnisch bestimmt werden, um die Länge des Resonators nachzuregeln. Ausgehend von einem Er- oder Ybfaserlaser-basiertem Frequenzkamm erhält man so eine breitbandig abstimmbare Dauerstrich-Lichtquelle im vis/nah-IR, bei der, wie oben, der momentane Phasenwert absolut bekannt ist.

**Bezugzeichenliste**

| 10 | Frequenzkamm |
|----|--------------|
| 12 | Einhüllende |
| 14 | Frequenz-Generator |
| 16 | Frequenzkamm-Lichtquelle |
| 18 | Frequenz-Synthesizer |
| 20 | Lichteingang |
| 22 | Arbeits-Lichtquelle ALQ |
| 24 | Arbeits-Licht |
| 28 | Regeleinrichtung |
| 30 | Regel-Differenz |
| 32 | Signalübertragungsvorrichtung |
| 34 | Phasen-Vergleichsglied |
| 36 | Phasen-Stellglied |
| 38 | Auskoppelvorrichtung |
| 40 | Lichtfeld |
| 42 | Kontroll-Einrichtung |
| 44 | Kurve |
| 46 | Kurve |

| $\nu$ | optische Frequenz |
|-------|-------------------|

| $\nu_C$ | Trägerfrequenz |
| $\nu_{CEO}$ | Versatzfrequenz (carrier envelope offset-Frequenz) |
| $\nu_{SL}$ | Arbeits-Frequenz |
| $\nu_{Soll}$ | Sollwert der Arbeitsfrequenz |
| $\nu_{Het}$ | Frequenzoffset bei der Heterodyn-Phasenregelung |
| $\nu_S$ | Schwebungs-Frequenz |
| $\Delta\nu$ | Frequenzverschiebung |
| $\varphi_S$ | Phasenstellung |
| $\Delta\varphi_S$ | Phasenstellungsfortschritt |
| $\varphi_A$ | Wert des Phasenakkumulator-Inhalts |
| $\varphi_{CE}$ | carrier-envelope-Frequenz |
| $\Delta\varphi_{CE}$ | Fortschritt der carrier-envelope-Frequenz |
| $E$ | elektrisches Feld |
| $f$ | Modulations-Frequenz, z.B. Mikrowellenfrequenz |
| $f_{REP}$ | Repetitionsfrequenz |
| $l_{RES}$ | Länge des Resonators |
| m | Laufindex der Kammlinien |
| $n$ | Laufindex der Impulse/Modulationsereignisse |
| $t$ | Zeit |
| $\tau$ | Repetitionszeit |
| $v_g$ | Gruppengeschwindigkeit |
| $v_p$ | Phasengeschwindigkeit |

**Patentansprüche**

1. Verfahren zum Erzeugen von phasenkohärentem Licht mit einem vorgebbaren Frequenzwert $\nu_{Soll}$, mit den Schritten

   (a) Erzeugen von Arbeits-Licht mit einer Arbeits-Frequenz $\nu_{SL}$,
   (b) Erzeugen eines Frequenzkamms (10), der ein Lichtfeld ist, das aus äquidistanten, phasenkohärenten Spektrallinien besteht,
   (c) Auswählen einer Kammlinie mit dem Laufindex m des Frequenzkamms (10) mit einer Frequenz $\nu_m$,
   (d) Erzeugen einer Frequenz-Verschiebung $\Delta\nu$ des Frequenzkamms (10) und/oder der Arbeits-Frequenz $\nu_{SL}$ durch zeitabhängige Phasenstellungen $\varphi_S(t)$ modulo eines Vielfachen von $2\pi$, insbesondere von $2\pi$, und
   (e) Phasenkopplung der ggf. frequenzverschobenen Felder des Arbeitslichts $\nu_{SL}$ und einer ggf. frequenzverschobenen Frequenzkammlinie $\nu_m$, so dass ihre Frequenzen über die Frequenz-Verschiebung $\Delta\nu$ phasenstarr gekoppelt sind und Arbeitslicht mit einer Soll-Frequenz $\nu_{Soll}$ erhalten wird.

2. Verfahren nach Anspruch 0, **dadurch gekennzeichnet, dass** die Änderungen der Phasenstellung $\varphi_S(t)$ zu Zeitpunkten $t_k$ durchgeführt werden, die einen zeitlichen Abstand voneinander von höchstens einer Inversen $\tau$ des Kammlinienabstandes $f_{REP}$ haben.

3. Verfahren nach einem der vorstehenden Ansprüche, **dadurch gekennzeichnet, dass** die Frequenz und/oder Phase des Lichtfelds der Arbeits-Lichtquelle und/oder des Frequenzkamms so geregelt wird, dass
   das Lichtfeld (24) der Arbeits-Lichtquelle (22) und
   das Lichtfeld der m-ten Kammlinie $\nu_m$
   unter Einschluss der Frequenz-Verschiebung $\Delta\nu$ eine wohldefinierte Phasenbeziehung zueinander haben.

4. Verfahren nach einem der vorstehenden Ansprüche, **dadurch gekennzeichnet, dass** die Arbeits-Frequenz $\nu_{SL}$ so voreingestellt wird, dass sie um weniger als 25% des Wertes der Repetitionsfrequenz $f_{REP}$ von der Soll-Frequenz $\nu_{Soll}$ entfernt ist.

5. Verfahren nach einem der vorstehenden Ansprüche zum Erzeugen von Licht mit einem sich mit der Zeit gemäß einem vorgegebenen Frequenzverlauf ändernden Wert der Soll-Frequenz $\nu_{Soll}(t)$, **dadurch gekennzeichnet, dass** der Wert $\Delta\nu(t)$ der Frequenz-Verschiebung dadurch mit der Zeit verändert wird, dass der Fortschritt der Phasenstellung $\varphi_s(t_k)$ mit der Zeit verändert wird.

6. Optischer Frequenz-Synthesizer mit

(i) einer abstimmbaren Arbeits-Lichtquelle (22) zum Abgeben von Arbeits-Licht (24) mit einer Arbeits-Frequenz $\nu_{SL}$,

(ii) einem Lichteingang (20) zum Einkoppeln eines Frequenzkamms (10), der ein Lichtfeld ist, das aus äquidistanten, phasenkohärenten Spektrallinien besteht, und

(iii) einem Phasen-Stellglied (36), das eingerichtet ist zum Erzeugen einer Frequenz-Verschiebung $\Delta\nu$ des Frequenzkamms (10) und/oder der Arbeits-Frequenz $\nu_{SL}$ durch Änderung seiner Phasenstellung $\varphi_S(t_k)$ modulo eines Vielfachen von $2\pi$, insbesondere von $2\pi$, wobei $t_k$ Zeitpunkte bezeichnet,

so dass durch zu periodisch wiederholten Zeitpunkten $t_k$ vorgenommene Änderungen der Phasenstellung $\varphi_S(t_k)$ eine Linie des Frequenzkamms (10) mit der Frequenz $\nu_m$ auf eine vorgegebene Soll-Frequenz $\nu_{Soll}$ verschiebbar ist.

7.   Optischer Frequenz-Synthesizer nach Anspruch 6, **gekennzeichnet durch**

(iv) eine Regelung (28) zum Regeln der Frequenz und/oder Phase des Lichtfeldes der Arbeits-Lichtquelle (22) und/oder einer Linie $\nu_m$ des Frequenzkamms (10), so dass ein Betrag $|\nu_{SL}\text{-}\nu_m \pm \Delta\nu|$ einer Differenz-Frequenz zwischen der um $\Delta\nu$ versetzten Arbeits-Frequenz und der Kammlinien-Frequenz und/oder der Arbeits-Frequenz und der um $\Delta\nu$ versetzten Kammlinien-Frequenz identisch wird mit einem vorgebbaren Heterodyn-Frequenzwert $\nu_{Het}$, der insbesondere den Wert 0 annehmen kann.

8.   Optischer Frequenz-Synthesizer nach Anspruch 6, **dadurch gekennzeichnet, dass** die Arbeits-Lichtquelle (22) einen Diodenlaser, insbesondere eine Laserdiode mit externem Resonator, umfasst.

9.   Optischer Frequenz-Synthesizer nach Anspruch 6, **dadurch gekennzeichnet, dass** die Arbeits-Lichtquelle (22) einen passiven optischen Resonator umfasst, der ein phasenkohärentes Arbeits-Lichtfeld aus einem eingestrahlten phasenkohärenten oder nicht phasenkohärenten Lichtfeld generieren kann.

10.  Optischer Frequenz-Synthesizer nach Anspruch 9, **dadurch gekennzeichnet, dass** durch ein nichtlinear-optisches Element innerhalb des Resonators aus in den passiven Resonator eingekoppelten Lichtfeldern, deren Summenfrequenz der Resonanzfrequenz $\nu_{SL}$ des Resonators entspricht, ein phasenkohärentes Lichtfeld mit der Arbeits-Frequenz $\nu_{SL}$ effizient erzeugt werden kann.

11.  Optischer Frequenz-Generator (14) mit

- einem optischen Frequenz-Synthesizer (18) nach einem der Ansprüche 6 bis 10 und
- einer Frequenzkamm-Lichtquelle (16) zum Erzeugen des Frequenzkamms (10), der als durch Modulation einer Trägerschwingung mit einer Trägerfrequenz $\nu_C$ durch eine komplexwertige Modulationsfunktion mit einer Repetitionsfrequenz $f_{REP}$ erhalten beschreibbar ist.

**Claims**

1.   Method for generating coherent-phase light having a predefinable frequency value $\nu_{Soll}$, comprising the steps of

(a) generating working light with a working frequency $\nu_{SL}$,
(b) generating a frequency comb (10), which is a light field that consists of equidistant coherent-phase spectral lines,
(c) selecting a comb line having the index m from the frequency comb (10) having a frequency $\nu_m$,
(d) generating a frequency shift $\Delta\nu$ of the frequency comb (10) and/or the working frequency $\nu_{SL}$ by means of time-dependent phase settings $\varphi_S(t)$ modulo a multiple of $2\pi$, in particular of $2\pi$, and
(e) phase-coupling the possibly frequency-shifted fields of the working light $\nu_{SL}$ and the one possibly frequency-shifted frequency comb line $\nu_m$, so that the frequencies thereof are rigidly phase-coupled via the frequency shift $\Delta\nu$, and working light having a desired frequency $\nu_{Soll}$ is obtained.

2.   Method according to claim 1, **characterized in that** the changes in phase setting $\varphi_S(t)$ are carried-out at points of time ($t_k$) that have a temporal distance from each other of maximally one inverse $\tau$ of the comb line distance $f_{REP}$.

3.   Method according to any of the preceding claims, **characterized in that** the frequencies and/or phase of the light field of the working light source and/or frequency comb is so controlled that

the light field (24) of the working light source (22) and
the light field of the m$^{th}$ comb line $v_m$
including the frequency shift $\Delta v$ have a well-defined phase relation to each other.

4. Method according to any of the preceding claims, **characterized in that** the working frequency $v_{SL}$ is so pre-set that it is by less than 25% of the value of the repetition frequency $f_{REP}$ away from the desired frequency $v_{Soll}$.

5. Method according to any of the preceding claims for generating light with a value of the desired frequency $v_{Soll}(t)$ varying in the course of time in accordance with a predefined frequency course, **characterized in that** the value $\Delta v(t)$ of the frequency shift is varied in the course of time by varying the progress of the phase setting $\varphi_S(t_k)$ in the course of time.

6. Optical frequency synthesizer comprised of

> (i) a tunable working light source (22) for emitting working light (24) with a working frequency $v_{SL}$,
> (ii) a light input (20) for coupling-in a frequency comb (10), which is a light field that consists of equidistant coherent-phase spectral lines, and
> (iii) a phase actuator element (36), which is set up for generating a frequency shift $\Delta v$ of the frequency comb (10) and/or working frequency $v_{SL}$ by varying its phase setting $\varphi_S(t_k)$ modulo a multiple of $2\pi$, in particular of $2\pi$, wherein $t_k$ indicates points of time,
> so that by means of changes in the phase setting $\varphi_S(t_k)$ carried-out at periodically repeated points of time $t_k$ a line of the frequency comb (10) having a frequency $v_m$ can be shifted to a predefined desired frequency $v_{Soll}$.

7. Optical frequency synthesizer according to claim 6, **characterized by**

> (iv) a control (28) for controlling the frequency and/or phase of the light field of the working light source (22) and/or a line $v_m$ of the frequency comb (10), so that an amount $|v_{SL}\text{-}v_m \pm \Delta v|$ of a differential frequency between the working frequency staggered by $\Delta v$ and the comb line frequency and/or of the working frequency and the comb line frequency staggered by $\Delta v$ becomes identical to a predefinable heterodyne frequency value $v_{Het}$, which in particular may assume the value 0.

8. Optical frequency synthesizer according to claim 6, **characterized in that** the working light source (22) comprises a diode laser, in particular a laser diode with external resonator.

9. Optical frequency synthesizer according to claim 6, **characterized in that** the working light source (22) comprises a passive optical resonator that can generate a coherent-phase working light field from an irradiated coherent-phase or non-coherent-phase light field.

10. Optical frequency synthesizer according to claim 9, **characterized in that** a coherent-phase light field having the working frequency $v_{SL}$ can be efficiently generated by means of a non-linear optical element within the resonator from light fields coupled into the passive resonator, the sum frequency of which corresponds to the resonance frequency $v_{SL}$ of the resonator.

11. Optical frequency generator (14) comprised of

> - an optical frequency synthesizer (18) according to any of the preceding claims 6 to 10, and
> - a frequency comb light source (16) for generating the frequency comb (10), which is describable as having been obtained by modulation of a carrier vibration with a carrier frequency $v_C$ by a complex-valued modulation function (14) with a repetition frequency $f_{REP}$.

**Revendications**

1. Procédé de production d'une lumière cohérente en phase, ayant une valeur de fréquence prédéfinissable $v_{Soll}$, comportant les étapes suivantes :

> (a) production d'une lumière de travail ayant une fréquence de travail $v_{SL}$,
> (b) production d'un peigne de fréquence (10), qui est un champ lumineux, lequel est constitué de raies spectrales équidistantes cohérentes en phase,

(c) sélection d'une raie du peigne, ayant l'indice courant m, du peigne de fréquence (10) avec une fréquence $\nu_m$,

(d) production d'un décalage de fréquence $\Delta\nu$ du peigne de fréquence (10) et/ou de la fréquence de travail $\nu_{SL}$ grâce à des positions de phase dépendant du temps $\varphi_S(t)$ modulo un multiple de $2\pi$, en particulier de $2\pi$, et

(e) couplage de phase des champs éventuellement décalés en phase de la lumière de travail $\nu_{SL}$ et d'une raie du peigne de fréquence éventuellement décalée en fréquence $\nu_m$, de façon que leurs fréquences soient couplées avec verrouillage de phase sur le décalage de fréquence $\Delta\nu$, et de façon à obtenir une lumière de travail ayant une fréquence de consigne $\nu_{Soll}$.

2. Procédé selon la revendication 0, **caractérisé en ce que** les variations de la position de phase $\varphi_S(t)$ sont réalisées à des instants $t_K$, qui présentent entre eux des écarts temporels au plus égaux à l'inverse $\tau$ de la distance entre les raies du peigne $f_{REP}$.

3. Procédé selon l'une des revendications précédentes, **caractérisé en ce que** la fréquence et/ou la phase du champ lumineux de la source lumineuse de travail et/ou du peigne de fréquence sont régulées de façon que le champ lumineux (24) de la source lumineuse de travail (22) et le champ lumineux de la m-ième raie de peigne $\nu_m$ présentent, avec prise en compte du décalage en fréquence $\Delta\nu$, une relation parfaitement définie entre les phases.

4. Procédé selon l'une des revendications précédentes, **caractérisé en ce que** la fréquence de travail $\nu_{SL}$ est préréglée de façon à s'écarter de la fréquence de consigne $\nu_{Soll}$ de moins de 25 % de la valeur de la fréquence de répétition $f_{REP}$.

5. Procédé selon l'une des revendications précédentes pour la production d'une lumière présentant une valeur de la fréquence de consigne $\nu_{Soll}(t)$ variant dans le temps selon une courbe de fréquence prédéfinie, **caractérisé en ce que** la valeur $\Delta\nu(t)$ du décalage de fréquence est modifiée dans le temps par le fait que l'avancement de la position de phase $\varphi_S(t_k)$ varie dans le temps.

6. Synthétiseur de fréquence optique, comportant

(i) une source de lumière de travail ajustable (22), pour émettre une lumière de travail (24) ayant une fréquence de travail $\nu_{SL}$,

(ii) une entrée de lumière (20) pour injecter un peigne de fréquence (10), qui est un champ lumineux constitué de raies spectrales équidistantes et cohérentes en phase, et

(iii) un élément de commande de phase (36), qui est configuré pour produire un décalage de fréquence $\Delta\nu$ du peigne de fréquence (10) et/ou de la fréquence de travail $\nu_{SL}$ par modification de sa position de phase $\varphi_s(t_k)$ modulo un multiple de $2\pi$, en particulier de $2\pi$, $t_k$ désignant des instants, de telle sorte que, sous l'effet de modifications de la position de phase $\varphi_s(t_k)$, réalisées à des instants périodiquement répétés $t_k$, une raie du peigne de fréquence (10) ayant la fréquence $\nu_m$ puisse être décalée à une fréquence de consigne prédéfinie $\nu_{Soll}$.

7. Synthétiseur de fréquence optique selon la revendication 6, **caractérisé par**

(iv) une régulation (28) pour réguler la fréquence et/ou la phase du champ lumineux de la source lumineuse de travail (22) et/ou d'une raie $\nu_m$ du peigne de fréquence (10), de façon qu'une valeur $|\nu_{SL}-\nu_m \pm \Delta\nu|$ d'une différence de fréquence entre la fréquence de travail décalée de $\Delta\nu$ et la fréquence des raies du peigne et/ou de la fréquence de travail et de la fréquence des raies du peigne décalées de $\Delta\nu$, soit identique à une valeur de fréquence hétérodyne prédéfinissable $\nu_{Het}$, qui en particulier peut prendre la valeur 0.

8. Synthétiseur de fréquence optique selon la revendication 6, **caractérisé en ce que** la source lumineuse de travail (22) comprend un laser à diode, en particulier une diode laser à résonateur extérieur.

9. Synthétiseur de fréquence optique selon la revendication 6, **caractérisé en ce que** la source lumineuse de travail (22) comprend un résonateur optique passif, qui peut générer un champ lumineux de travail cohérent en phase à partir d'un champ lumineux cohérent en phase ou non cohérent en phase irradié.

10. Synthétiseur de fréquence optique selon la revendication 9, **caractérisé en ce que**, grâce à un élément optique non linéaire à l'intérieur du résonateur, il est possible de produire efficacement, à partir des champs lumineux injectés dans le résonateur passif, dont la fréquence totale correspond à la fréquence de résonance $\nu_{SL}$ du résonateur, un champ lumineux cohérent en phase ayant la fréquence de travail $\nu_{SL}$.

**11.** Générateur de fréquence optique (14), comportant

- un synthétiseur de fréquence optique (18) selon l'une des revendications 6 à 10, et
- une source lumineuse en peigne de fréquence (16) pour produire le peigne de fréquence (10), qui peut être décrit comme obtenu par modulation d'une oscillation porteuse ayant une fréquence porteuse $\nu_C$, par une fonction de modulation complexe ayant une fréquence de répétition $f_{REP}$.

Abb. 1

Abb. 2

Störgrößen

Führungsgröße → Stellglied → *Stellgröße* → Steuer-Strecke → *gesteuerte Größe*

## Abb. 3a

phasenkohärente Lichtquelle

$E \propto sin\ (2\pi vt)$

*Führungsgröße:*
Phasenstellung $\varphi_S(t)$
(als Binärzahl) → DAC → EOM → *Stellgröße:* optische Weglänge/Laufzeit im EOM → Steuer-Strecke

Phasen-Stellglied

*gesteuerte Größe:*
Phasenwinkel $\varphi$,
$E \propto sin\ (2\pi vt + \varphi_S(t))$

## Abb. 3b

Takt $f_{REP}$

(Frequenz-)
Führungsgröße → $\Sigma$ → MSBs des Akkumulator-Inhalts $\varphi_A$

*(Phasen-)*
*Führungsgröße* → Phasen Stellglied → Steuer-Strecke

Phasen-akkumulator

Frequenz-Stellglied

Frequenzkamm-Lichtquelle

$E_m \propto sin\ (2\pi v_m t)$

*gesteuerte Größe:*
Frequenz bzw. Phases des verschobenen Kammlinien-Feldes

## Abb. 3c

**Abb. 4a**

**Abb. 4b**

**Abb. 4c**

14

18

Beispiel für ein
optisches Homodyn-
Phasenvergleichsglied

Frequenzkamm-Licht

Arbeitslicht

Photodioden

zur Arbeits-
Lichtquelle

34

28

30

32

38

$v = \nu_m + \Delta\nu$

$v = \nu_m$

$v = \nu_u$

36

42

22

16

20

**Abb. 5a**

Abb. 5b

Abb. 6

Abb. 7

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 02099939 A2

**In der Beschreibung aufgeführte Nicht-Patentliteratur**

- **N. BEVERINI et al.** Solid State Lasers and Nonlinear Frequency Conversion, Proceedings of the SPIE. *Laser Optics,* 2003, vol. 5478 (1), 194-203

- **H.R. TELLE ; B. LIPPHARDT ; J. STENGER.** Kerr-lens, mode-locked lasers as transfer oszillators for optical frequency measurements. *Appl. Phys. B,* 2002, vol. 74, 1-6